# EUROPEAN PATENT APPLICATION

(11) **EP 2 595 209 A1**
(43) Date of publication of application: **22.05.2013**
(21) Application number: 11189423.4
(22) Date of filing: 16.11.2011
(51) Int. Cl.: H01L 51/52, H01L 51/44, H01L 51/10, H01L 51/00, H01L 31/048

(54) **Electronic device having a barrier film, barrier film for electronic devices, and use of and process for manufacturing the same**

(71) Applicant: SOLVAY SA, 1120 Bruxelles (BE)
(72) Inventor: Braun, Max Josef, 30900 WEDEMARK (DE)
(74) Representative: Mross, Stefan P.M.

(57) **Abstract**

Electronic devices comprising a barrier film having at least one fluorinated surface, the barrier film having at least one fluorinated surface and its use as protection coating for the electronic device and the method for manufacturing thereof. The barrier film having at least one fluorinated surface according to the present invention can be obtained by a simple method, as well as in cost-efficient manner.

## Description

### TECHNICAL FIELD

The present invention related to electronic devices having a barrier film, to the barrier film, to the use of the barrier film as a protection coating, and to a process for manufacturing the same. More particularly, the present invention related to electronic devices comprising a barrier film having at least one fluorinated surface, and to the barrier film having at least one fluorinated surface and to its use as protection coating and method for manufacturing thereof. The barrier film having at least one fluorinated surface according to the present invention can be obtained by a simple method, as well as in cost-efficient manner.

### BACKGROUND OF THE INVENTION

Electronic devices require flexible and mechanical strength films as key component to replace existing glass and metals. The films for electronic devices used under harsh environments, such as protective coatings and back-plains for photovoltaics and various organic devices (e.g. organic light-emitting diodes) must demonstrate an extremely high level of barrier property to block moisture, air and environmental impurities from deteriorating electronic devices, and on the other hand, these films need to remain transparent over time.

Industry is especially turning to photovoltaic devices which convert sunlight into electrical current, with increasing energy prices and with increasing concern over the environmental impact of hydrocarbon fuels. Although one of the advantages that photovoltaic devices have is low ongoing operational costs, much of the expense of installing a photovoltaic device is in upfront equipment costs. As such, economic viability of a photovoltaic device is strongly dependent upon equipment cost and durability.

During their use, photovoltaic devices are exposed to extreme weather conditions. To protect the photovoltaic devices, coatings such as encapsulants and/or other polymer films are disposed over the surfaces of the devices. However, such coatings themselves are susceptible to extreme weather conditions and may degrade over time. Such degradation may expose the photovoltaic devices to the surrounding environments, leading to damage to the devices. US 5,530,264 discloses a photoelectric conversion device comprising : (a) a photoelectric conversion element ; (b) a transparent resin layer (filler layer) comprising a fluorine-based resin, in particular a chlorotrifluoroethylene/vinyl ether or vinyl ester copolymer, crosslinked with a peroxide ; and (c) a transparent surface layer, e.g. a PVDF film or an ECTFE film, generally submitted to surface treatment for achieving adhesion to layer (b).

Although such endeavors may finally lead to fulfillment of certain required properties of the coatings, on the other hand, the resulting coatings often require difficult and complicated processes in their manufacturing, which sometimes lead to very high cost. Despite the attractiveness of the low environmental impact of solar energy solutions, high cost concerns could influence the competitiveness of photovoltaic systems relative to other energy sources.

### DESCRIPTION OF THE INVENTION

The present invention, therefore, relates to an electronic device comprising a barrier film having at least one fluorinated surface. The present invention makes it available to obtain the cost-competitive protection coatings which protect the electronic device from moisture, gas such as oxygen, and environmental impurities. The presence of fluorine atoms in materials may impart moisture and oxygen rejecting properties thereto as well as protect plastics from liquids to permeate through. For example, although barrier films comprising certain fluoropolymers have been developed as described above, unfortunately, the monomers as raw materials for those fluoropolymers are either not available in industrial scale or are very expensive so that the industry sectors applying the barrier films comprising such fluoropolymers are not able to meet their economic targets. It is shown in the present invention that, by imparting at least one fluorinated surface to a barrier film for electronic devices, the properties of the barrier film are strongly improved, while maintaining the cost-competitiveness.

### BRIEF DESCRIPTION OF THE DRAWING(S)

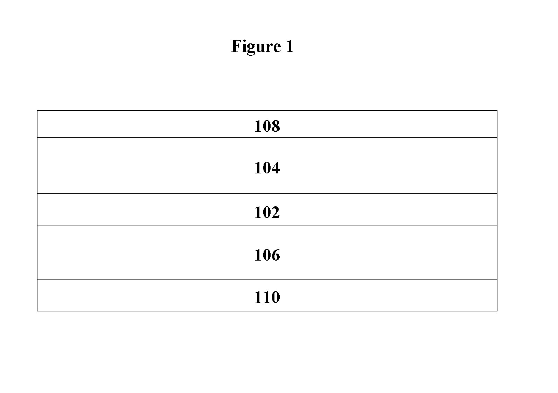

Figure 1 shows a simple structure of photovoltaic device, comprising a photovoltaic-element 102, a front side filler layer 104, a back side filler layer 106, a front side barrier film 108 and a back side barrier film 110. In one example, the front side filler layer 104 and the back side filler layer 106 can function as or include an encapsulant. In particular example, the front side barrier film 108 and the back side barrier film 110 can be one or multiple layer films.

### DETAILED DESCRIPTION OF THE INVENTION

In the present invention, "fluorinated surface" is understood to denote in particular a surface which has been obtained by fluorination of a preexisting surface.

The present invention will be described by way of embodiments, which should not be construed as limiting the present invention. It should be understood that various modifications and improvements may be made within the scope of the present invention based on knowledge of a person skilled in the art.

The electronic devices according to the present invention can be any environmentally sensitive devices requiring protection from moisture, gas, heat, or other contaminants, or generally from environment. The electronic devices of the present invention include, but are not limited to, organic light emitting devices, liquid crystal displays, displays using electrophoretic inks, light emitting diodes, light emitting polymers, electroluminescent devices, photovoltaic devices, thin film batteries, microelectromechanical systems (MEMS), and electro-optic polymer modulators. The electronic device according to the present invention is in particular a photovoltaic device. In the present invention, a meaning of "a photovoltaic device" includes both a photovoltaic cell and a photovoltaic module.

The barrier films of the present invention may comprise a layer of a single or multiple components, or multiple layers in which each layer is made of the same or different components. For instance, the barrier film according to the present invention may comprise protective layer(s), adhesive layer(s), decoupling layer(s), UV radiation absorber(s), light stabilizer(s), antioxidant(s), encapsulation layer(s) and/or inorganic layer(s), or any combination thereof. In a particular aspect, the barrier film according to the invention comprises all aforesaid components.

The protective layer can include at least one polymer selected from fluorinated and, preferably, non-fluorinated polymers. Particular examples of non-fluorinated polymers are selected from the group consisting of polyolefins such as polyethylenes and polypropylenes, polyesters, polycarbonates chlorinated polymers such as polyvinylchloride and polyvinylidenechloride. Polyolefins are more particularly preferred.

Preferably, the protective layer constitutes the fluorinated surface of the barrier film according to the invention.

When the protective layer comprises a polyester, said polyester can be selected, for example, from polyethylene terephthalate (PET), polyethylene naphthalate (PEN), polybutylene terephthalate (PBT) and polycyclohexanedimethanol terephthalate (PCT).

When the protective layer comprises a fluoropolymer, said fluoropolymer can be selected, for example, from polyvinylidene fluoride (PVDF), polyvinyl fluoride (PVF), polytetrafluoroethylene (PTFE), a copolymer of tetrafluoroethylene and perfluoro methylvinylether (PFA), ethylene tetrafluoroethylene copolymer (ETFE), polychlorotrifluoroethylene (PCTFE), ethylene chlorotrifluoroethylene copolymer (ECTFE), fluorinated ethylene propylene copolymer (FEP), a copolymer of ethylene and fluorinated ethylene propylene (EFEP), a terpolymer of tetrafluoroethylene, hexafluoropropylene, and vinylidene fluoride (THV), a terpolymer of tetrafluoroethylene, hexafluoropropylene, and ethylene (HTE), or any combination thereof.

Non-limiting examples of the material for an optionally present adhesive layer include a polyurethane, ethylene vinyl acetate (EVA), polyester (PET), a cyanoacrylate, epoxy, phenolics, an olefin, hot melt adhesives, ionomers, silicone, acrylics, a copolymer thereof, or a combination thereof.

In one embodiment, the barrier film comprises a decoupling layer. In that case, the decoupling layer may comprise any suitable decoupling material, including, but not limited to, organic polymers, inorganic polymers, organometallic polymers, hybrid organic/inorganic polymer systems, and any combination thereof.

In this embodiment, the organic polymers can be suitably selected from polyacetate, polypropylene, cellophane, poly(1-trimethylsilyl-1-propyne), poly(ethylene-2,6-naphthalene dicarboxylate) (PEN), polyethylene terephthalate (PET), poly(4-methyl-2-pentyne), polyimide, polycarbonate (PC), polyethylene, polyethersulfone, epoxy resin, polyethylene terephthalate, polystyrene, polyurethane, polyacrylate, polyacrylamide, polydimethylphenylene oxide, styrene-divinylbenzene copolymer, nylon, nitrocellulose, cellulose, acetate, and any combination thereof.

In this embodiment, the inorganic polymers can be suitably selected from silicones, polyphosphazenes, polysilazanes, polycarbosilanes, polycarboranes, carborane siloxanes, polysilanes, phosphonitriles, sulfur nitride polymers, siloxanes, and combinations thereof.

In this embodiment, the organometallic polymers can be suitably selected from organometallic polymers of main group metals, transition metals, and lanthanide/actinide metals, or combinations thereof.

In this embodiment, the hybrid organic/inorganic polymer systems can be suitably selected from organically modified silicates, preceramic polymers, polyimide-silica hybrids, (meth)acrylate-silica hybrids, polydimethylsiloxane-silica hybrids, and combinations thereof.

If an UV radiation absorber is present, it can be, for example, an organic UV radiation absorber, such as an UV radiation absorber comprising a benzotriazole moiety, e.g. 2,4-di-tert-butyl-6-(5-chlorobenzotriazol-2-yl) phenol or 2-(2H- benzotriazol-2-yl)-p-cresol, the triazine class, e.g. 2-(4,6-diphenyl-1,3,5-triazin-2-yl)-5-hexyloxy-phenol, the benzophenone class, the cyanoacrylate class, the benzoxazinone class, the oxanilide class, or combinations thereof and/or inorganic UV radiation absorber which can include titanium dioxide or zinc oxide.

If a light stabilizer is present it can be, for example, a hindered amine light stabilizer, for example bis(2,2,6,6,-tetramethyl-4- piperidyl)sebacate.

If an antioxidant is present, it is suitably selected from a phosphite antioxidant, a phenolic antioxidant, a sulfide antioxidant, an amine antioxidant, or a combination thereof.

If the barrier film according to the invention comprises an encapsulation layer said encapsulation layer suitably comprises natural or synthetic polymers in particular selected from polyethylene (including linear low density polyethylene, low density polyethylene, high density polyethylene, etc.), polypropylene, nylons (polyamides), EPDM, polyesters, polycarbonates, ethylene-propylene elastomer copolymers, copolymers of ethylene or propylene with acrylic or methacrylic acids, acrylates, methacrylates, ethylene-propylene copolymers, poly alpha olefin melt adhesives such including, for example, ethylene vinyl acetate (EVA), ethylene butyl acrylate (EBA), ethylene methyl acrylate (EMA) ; ionomers (acid functionalized polyolefins generally neutralized as a metal salt), acid functionalized polyolefins, polyurethanes including, for example, thermoplastic polyurethane (TPU), olefin elastomers, olefinic block copolymers, thermoplastic silicones, polyvinyl butyral, a fluoropolymer, such as a terpolymer of tetrafluoroethylene, hexafluoropropylene, and vinylidene fluoride or any combination thereof.

If the barrier film according to the invention comprises an inorganic layer said layer may comprise a metal. Specific examples of metals are selected from aluminum, silver, gold, titanium, tin, zinc or a combination thereof. Said inorganic layer may also comprise a metal oxide. Specific examples of metal oxides are selected from alumina, silica, tin oxide, zinc oxide or a combination thereof. Said inorganic layer may also comprise a metal nitride. Specific examples of metal nitrides are selected from aluminum nitride, titanium nitride, silicon nitride, zinc nitride or a combination thereof. Said inorganic layer may also comprise a metal carbide. Specific examples of metal carbides are selected from aluminum carbide, titanium carbide, silicon carbide or a combination thereof.

While certain layers or components have been described herein before with regard to a specific function, it is contemplated that multiple layers and/or components may contribute to the same specific function and that a single layer and/or component may contribute to several functions.

In case that the barrier film according to the present invention is multilayer film, the outermost layer to the environment is preferably a protective layer as defined above. In this case, said outermost layer preferably comprises at least one non-fluorinated polymer as described above in the context of a protective layer. This embodiment gives particularly interesting barrier properties against the environment. In such a case, the at least one fluorinated surface of the barrier film can be formed on said outermost surface of protective layer, preferably comprising at least one non-fluorinated polymer as defined above.

The barrier film according to the present invention preferably has a visible light transmission of equal to or greater than 75 %. For example, the visible light transmission can be equal to or greater than 85 %, more preferably equal to or greater than 90 %, still more preferably equal to or greater than 92 %. The visible light transmission is understood to denote light transmission for wavelengths between 400 nm and 750 nm, and to include electromagnetic radiation having wavelengths in a range of 400 nm and 750 nm.

The thickness of the barrier film according to the present invention is generally equal to or greater than 10 µm, preferably equal to or greater than 15 µm, more preferably equal to or greater than 20 µm, still more preferably equal to or greater than 25 µm. The thickness of the barrier film according to the present invention is generally equal to or less than 1000 µm, more particularly equal to or less than 250 µm, still more particularly equal to or less than 200 µm.

The invention also concerns a process for the manufacture of the barrier film according to the invention. In the process according to the invention, the fluorinated surface is generally obtained, by treating at least one surface of the barrier film with an atmosphere containing reactive F ions or F radicals. Any source gas for fluorine generation can be used. In a particular embodiment of the present invention, the source gas for the F ions or F radicals can be selected from the group consisting of F₂, SF₆, SOF₂, COF₂, CF₃COF, SF₄, SO₂FCl, CF₂ClCOF, SO₂F₂, and any combination thereof. In a more particular embodiment, the atmosphere containing reactive F ions or F radicals comprises F₂ gas.

In a particular aspect, which is preferred, the atmosphere containing reactive F ions or F radicals further contains one or more assist gases, such as an inert gas. Examples of the inert gases include CO₂, N₂, and noble gases such as He, Ar, or any combination thereof.

In a particular embodiment of the present invention, the surface-treatment of the barrier film is performed by placing the barrier film in a chamber and providing the chamber with an atmosphere containing reactive F ions or F radicals, as described above. This embodiment generally further comprises flowing the atmosphere containing reactive F ions or F radicals and/or the source gas, and optional assist gas into the chamber, which can optionally be sealed during the treatment, and removing said atmosphere after a certain exposure time so as to obtain the barrier film having fluorinated surface. The formation of F ions or F radicals from F₂, SF₆, SOF₂, COF₂, CF₃COF, SF₄, SO₂FCl, CF₂ClCOF, SO₂F₂, and any combination thereof can be promoted in any desired manner, e.g. by applying heat, irradiation of light or by applying a plasma. F₂, optionally in mixture with inert gas, is often reactive enough such that no promotion of the formation of reactive F species is necessary. Optionally, during the surface-treatment process in the chamber, the atmosphere is further diluted with one or more inert gas. By applying this optional process, additional cost saving can be achieved.

The barrier film obtainable by the process of the present invention has improved barrier properties compared to a barrier film having no fluorinated surface, in particular concerning moisture barrier property, gas barrier property and weather resistance. It can be manufactured in using a technically simple and cost-competitive process.

The barrier film having at least one fluorinated surface can be applied to an electronic device by any suitable methods. In a particular embodiment, the barrier film having at least one fluorinated surface can be laminated to an electronic device, in particular a photovoltaic element to form the electronic device, in particular the photovoltaic device comprising the barrier film.

A particular photovoltaic device according to the invention may comprise at least a front-plane, photovoltaic-element comprising electrode layer(s) and a photovoltaic-active layer, and a back-plane, and the photovoltaic-element can be dispensed on a substrate and the barrier film having at least one fluorinated surface according to the present invention. Either the front-plane or the back-plane, or both of them can comprise the barrier film having at least one fluorinated surface. Alternatively, the barrier film can be treated with an atmosphere containing reactive F ions or F radicals after a lamination to an electronic device.

Accordingly, the present invention also relates to a use of the barrier film having at least one fluorinated surface, as a protection coating for electronic devices, especially for photovoltaic devices.

While preferred embodiments of this invention have been shown and described, modifications thereof can be made by one skilled in the art without departing from the spirit or teaching of this invention. The embodiments and examples described herein are exemplary only and are not limiting. Many variations and modifications of systems and methods are possible and are within the scope of the invention.

### Examples

### Example 1 : Manufacture of a surface-fluorinated barrier film based on PE

### (polyethylene) polymer

The extrusion of PE polymer is carried out in a conventional film extrusion line. The pellets of the PE polymer are charged into the hopper of an extruder. The barrel of the extruder, the die and the connecting parts between the barrel and the die are also heated. The PE polymer is extruded through the die. The resulting PE film is smooth film, having a thickness of about 50 µm. The resulting PE is placed in a chamber. After the chamber is sealed, inside of the chamber is filled with the atmosphere containing F₂ gas. After an exposure time, the atmosphere is removed from the chamber, and the PE film having fluorinated surface is obtained.

### Example 2 : Manufacture of a photovoltaic device comprising a protective coating containing the surface-fluorinated barrier film

The PE film obtained from example 1 is used for both front-plane and back-plane of the photovoltaic device. The films for front-plane and back-plane are provided to extend beyond perimeter of the surface of a photovoltaic-element. The photovoltaic-element and the films are assembled so that the light receiving surface of the photovoltaic-element is entirely covered by said front-plane and that said front-plane and the back-plane are in intimate contact all around the periphery of the surface of the photovoltaic-element. Thereafter, the thermal treatment is applied to the assembly, by introducing the assembly to the preheated heating press and heating the same with optional pressure. Then, the assembly is slowly cooled down at room temperature, so as to obtain a photovoltaic device having a photovoltaic-element encapsulated between the front-plane and the back-plane.

Thus obtained photovoltaic device is found to show increased protection of the photovoltaic-element from the environment.

## Claims

1. An electronic device comprising a barrier film having at least one fluorinated surface.

2. The electronic device according to Claim 1, wherein the fluorinated surface is obtained by fluorination of a non-fluorinated polymer layer, in particular a protective layer.

3. The electronic device according to Claim 1 or 2, wherein the barrier film comprises at least one protective layer which includes at least one polymer selected from the group consisting of polyethylenes, polypropylenes, polyesters, polycarbonates and fluoropolymers.

4. The electronic device according to anyone of Claims 1 to 3, wherein the fluorinated surface does not comprise a fluoropolymer.

5. The electronic device according to anyone of Claim 1 to 4, wherein the polyester is selected from the group consisting of polyethylene terephthalate (PET), polyethylene naphthalate (PEN), polybutylene terephthalate (PBT) and polycyclohexanedimethanol terephthalate (PCT).

6. The electronic device according to Claim 1, wherein the fluorinated surface is obtained by fluorination fluoropolymer selected from the group consisting of polyvinylidene fluoride (PVDF), polyvinyl fluoride (PVF), polytetrafluoroethylene (PTFE), a copolymer of tetrafluoroethylene and perfluoro methylvinylether (PFA), ethylene tetrafluoroethylene copolymer (ETFE), polychlorotrifluoroethylene (PCTFE), ethylene chlorotrifluoroethylene copolymer (ECTFE), fluorinated ethylene propylene copolymer (FEP), a copolymer of ethylene and fluorinated ethylene propylene (EFEP), a terpolymer of tetrafluoroethylene, hexafluoropropylene, and vinylidene fluoride (THV), a terpolymer of tetrafluoroethylene, hexafluoropropylene, and ethylene (HTE), and any combination thereof.

7. The electronic device according to any one of Claims 1 to 6, wherein the barrier film has a visible light transmission of equal to or greater than 75 %, preferably equal to or greater than 85 %, more preferably equal to or greater than 90 %, still more preferably equal to or greater than 92 %.

8. The electronic device according to any one of Claims 1 to 7, wherein the thickness of the barrier film is from 10 µm to 1000 µm.

9. The electronic device according to any one of Claims 1 to 8, selected from the group consisting of organic light emitting devices, liquid crystal displays, displays using electrophoretic inks, light emitting diodes, light emitting polymers, electroluminescent devices, photovoltaic devices, thin film batteries, microelectromechanical systems (MEMS), and electro-optic polymer modulators, preferably photovoltaic devices.

10. The electronic device according to any one of Claims 1 to 9, obtainable by a surface-treatment of the barrier film with an atmosphere containing reactive F ions or F radicals.

11. The electronic device according to Claim 10, wherein the atmosphere comprises at least one source gas for the F ions or F radicals selected from the group consisting of F₂, SF₆, SOF₂, COF₂, CF₃COF, SF₄, SO₂FCl, CF₂ClCOF, SO₂F₂ and any combination thereof, preferably F₂.

12. The electronic device according to Claim 11, wherein during the surface-treatment of the barrier film, the source gas is diluted with one or more inert gases.

13. A barrier film having at least one fluorinated surface in which the barrier film is applicable in the electronic device according to Claims 1 to 12, comprises at least one protective layer which includes at least one polymer selected from the group consisting of polyethylenes, polypropylenes, polyesters, polycarbonates and fluoropolymers, wherein a thickness of the barrier film is from 10 µm to 1000 µm.

14. A method of manufacturing the barrier film according to Claim 13, comprising a step of treating at least one surface of a barrier film with an atmosphere containing reactive F ions or F radicals.

15. Use of the barrier film having at least one fluorinated surface according to Claim 13, as a protection coating for electronic devices, preferably for photovoltaic devices.
